# FASCICULE DE BREVET EUROPEEN

(11) **EP 3 668 289 B1**
(45) Date de publication et mention de la délivrance du brevet: **26.04.2023**
(21) Numéro de dépôt: 19213459.1
(22) Date de dépôt: 04.12.2019
(51) Int. Cl.: H05K 7/14

(54) **EQUIPEMENT ELECTRIQUE COMPORTANT UN FILM ISOLANT REPLIE SUR LUI-MEME**
ELEKTRISCHE VORRICHTUNG MIT EINER AUFGEFALTETEN ISOLIERENDEN FOLIE
ELECTRICAL DEVICE COMPRISING A FOLDED-ON INSULATING FILM

(30) Priorité: 14.12.2018 FR 1872986
(43) Date de publication de la demande: 17.06.2020
(73) Titulaire: Valeo eAutomotive France SAS, 95800 Cergy (FR)
(72) Inventeur: MORTAIN, Eloi, 92150 SURESNES (FR); MOCERI, Alwin, 78700 CONFLANS SAINTE-HONORINE (FR); PARIGOT, Baptiste, 78290 CROISSY-SUR-SEINE (FR)
(74) Mandataire: Valeo Powertrain Systems

(56) Documents cités:
- EP-A1- 1 788 596
- EP-A1- 2 928 059
- US-A1- 2015 155 692
- US-A1- 2018 358 903

## Description

### DOMAINE TECHNIQUE DE L'INVENTION

La présente invention concerne un dispositif électrique présentant un système d'isolation électrique amélioré et un équipement électrique comprenant un tel dispositif électrique, notamment un convertisseur de tension, ou un chargeur électrique ou un onduleur.

L'équipement électrique est notamment destiné à un véhicule électrique ou hybride.

L'invention vise notamment à permettre une isolation électrique durable pour de tels dispositifs électriques.

### ETAT DE LA TECHNIQUE

Comme cela est connu, dans un véhicule automobile électrique ou hybride, une batterie d'alimentation haute tension assure une fonction d'alimentation en énergie électrique d'un système de motorisation électrique permettant la propulsion du véhicule. Plus précisément, afin de commander la machine électrique entrainant les roues du véhicule, il est connu d'utiliser un onduleur permettant de convertir le courant continu fourni par la batterie d'alimentation haute tension en un ou plusieurs courants de commande alternatifs, par exemple sinusoïdaux.

Par ailleurs, afin d'être chargée, la batterie d'alimentation haute tension est par exemple connectée à un réseau électrique d'alimentation externe, notamment via un chargeur électrique embarqué comprenant notamment au moins un convertisseur de tension continu-continu.

L'onduleur comprend un logement, dédié à cet équipement et communément appelé « housing » par l'homme du métier. L'onduleur comprend également un bloc capacitif comprenant un boîtier adapté pour s'insérer dans le logement de l'onduleur. Le bloc capacitif comprend également une cavité, située à l'intérieur du boîtier, et une capacité de lissage, adaptée pour être insérée dans la cavité du boîtier. Le bloc capacitif permet de lisser le courant continu fourni par la batterie d'alimentation, avant sa conversion en un courant de commande alternatif. Cette capacité permet ainsi de supprimer les perturbations résiduelles du courant continu afin qu'il puisse être filtré et être converti en un courant de commande alternatif.

Le bloc capacitif comprend également au moins deux conducteurs, notamment un conducteur relié à la borne négative de la capacité et un conducteur relié à la borne positive de la capacité. Chaque conducteur se présente comme une lamelle en cuivre pliée par exemple. Ces conducteurs permettent ainsi de donner un accès simple aux bornes négative et positive de la capacité, afin de connecter simplement la capacité au reste du système.

Cependant les conducteurs sont disposés selon des plans parallèles distincts mais à proximité l'un de l'autre. Ainsi, une isolation doit être réalisée entre les conducteurs et également entre les conducteurs et le logement afin d'isoler ces éléments les uns des autres pour éviter tout risque de court-circuit pouvant empêcher un fonctionnement optimal de l'onduleur.

Selon l'état de la technique, une première solution consiste à utiliser un premier film isolant à placer entre les conducteurs et le logement et un deuxième film isolant à placer entre les conducteurs. Selon cette solution, le premier et le deuxième film isolants sont maintenus immobiles en les fixant notamment avec une matière adhésive, telle que de la colle.

Le document EP 2928059 A1 décrit un exemple d'onduleur connu comprenant des conducteurs séparés par des couches d'isolation électrique.

Cependant, toute matière adhésive a une durée de vie très limitée et largement inférieure à la durée de vie d'un véhicule en tout genre. Il est donc possible que la matière adhésive se détériore avec le temps et que des problèmes de courts-circuits surviennent.

Il existe donc un besoin pour une solution efficace et durable d'un système de fixation d'éléments d'isolation des différents éléments d'un équipement électrique, notamment d'un bloc capacitif.

### PRESENTATION DE L'INVENTION

Plus précisément, l'invention a pour objet un dispositif électrique comprenant :
un boîtier comprenant une cavité recevant un composant électrique, et
au moins deux conducteurs connectés au composant électrique de manière à l'alimenter en énergie électrique, les deux conducteurs étant superposés et s'étendant parallèlement,
ledit dispositif étant caractérisé en ce qu'il comprend un film isolant électrique replié sur lui-même autour d'une pliure, et dont une première partie située d'un côté de la pliure vient contre une surface d'un premier conducteur de manière à l'isoler électriquement, et une deuxième partie située de l'autre côté de la pliure est insérée entre les deux conducteurs de manière à les isoler électriquement l'un de l'autre.

De manière préférée, la pliure du film isolant du dispositif électrique comprend au moins une ouverture adaptée pour laisser un accès libre aux conducteurs.

Avantageusement, la première partie et la deuxième partie du film isolant du dispositif électrique possèdent chacune au moins une excroissance configurée pour s'insérer dans la cavité du boîtier et pour être prise dans un matériau de remplissage de la cavité du boîtier.

De manière avantageuse, le dispositif électrique forme un bloc capacitif et le composant électrique est une bobine capacitive.

De préférence, selon une forme de réalisation, la première partie du film isolant du dispositif électrique présente au moins un pli de manière à épouser la surface du premier conducteur et est maintenue contre ladite surface du premier conducteur uniquement par l'excroissance et la pliure.

De manière préférée, selon une autre forme de réalisation, la première partie du dispositif électrique est maintenue sur la surface du premier conducteur par une matière adhésive.

Avantageusement, le film isolant est en plastique.

L'invention concerne également un équipement électrique comprenant un logement et un dispositif électrique selon l'une des revendications précédentes logé dans ledit logement, équipement électrique dans lequel ledit film isolant électrique, et en particulier la première partie du film isolant électrique, est configuré pour isoler électriquement le premier conducteur d'une paroi dudit logement de l'équipement électrique ou d'autres composants de l'équipement électrique situés dans ledit logement de l'équipement électrique, ledit film isolant électrique, et en particulier la deuxième partie du film isolant électrique, est configuré pour isoler les conducteurs les uns des autres.

De manière préférée, l'équipement électrique est configuré pour être embarqué dans un véhicule, et formant un onduleur configuré de manière à alimenter un moteur électrique entrainant le véhicule depuis une batterie, ou un convertisseur continu-continu configuré pour convertir une tension entre une batterie d'alimentation haute tension et une batterie d'alimentation basse tension, ou un chargeur électrique configuré pour convertir une tension entre un réseau électrique extérieur au véhicule et une batterie du véhicule.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
Fig. 1 illustre le schéma d'un bloc capacitif ;
Fig. 2 illustre le schéma des conducteurs du bloc capacitif illustré à la figure 1 ;
Fig. 3 représente le schéma du boîtier du bloc capacitif selon la figure 1 et d'un film isolant selon l'invention ;
Fig. 4 représente le schéma des conducteurs du bloc capacitif illustré à la figure 1 et du film isolant selon l'invention ;
Fig. 5 représente le film isolant seul selon l'invention ;
Fig. 6 représente un équipement électrique selon l'invention.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

Dans la description qui sera faite ci-après, l'invention sera décrite notamment dans le contexte d'un équipement électrique, tel qu'un onduleur, destiné à un véhicule automobile électrique ou hybride sans que cela ne soit limitatif de la portée de la présente invention.

En effet, dans un véhicule automobile électrique ou hybride, la batterie d'alimentation haute tension assure la fonction d'alimentation en énergie électrique du système de motorisation électrique, permettant la propulsion du véhicule, notamment via un onduleur permettant de convertir le courant continu fourni par la batterie d'alimentation haute tension en un ou plusieurs courants de commande alternatifs, par exemple sinusoïdaux.

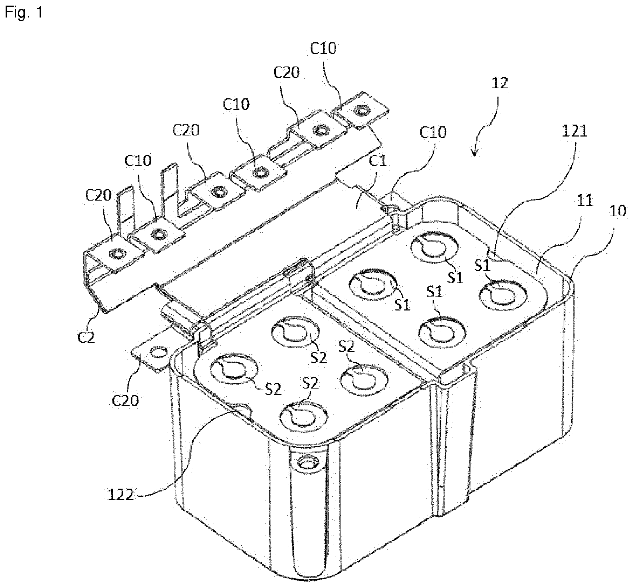

En référence à la figure 1, l'équipement électrique comprend un logement, qui lui est dédié, et communément appelé « housing » par l'homme du métier. Dans le cas présent, cet équipement électrique est un onduleur. L'onduleur comprend un bloc capacitif 12 comprenant un boîtier 10 adapté pour s'insérer dans le logement. Le bloc capacitif 12 comprend également une cavité 11, située à l'intérieur du boîtier 10, notamment définie par le boitier 10. Le bloc capacitif 12 comprend en outre des éléments capacitifs 121, 122, adaptés pour être insérés dans la cavité 11 du boîtier 10. Le bloc capacitif 12 permet de lisser le courant continu fourni par la batterie d'alimentation, avant sa conversion en un courant de commande alternatif. Ce bloc capacitif 12 comprenant une borne positive et une borne négative, permet ainsi de supprimer les perturbations résiduelles du courant continu afin qu'il puisse être filtré et être converti en un courant de commande alternatif, notamment par des interrupteurs électroniques non représentés. Les éléments capacitifs 121, 122 sont par exemple des capacités chimiques ou des capacités film, ou tout autre type d'élément capacitif.

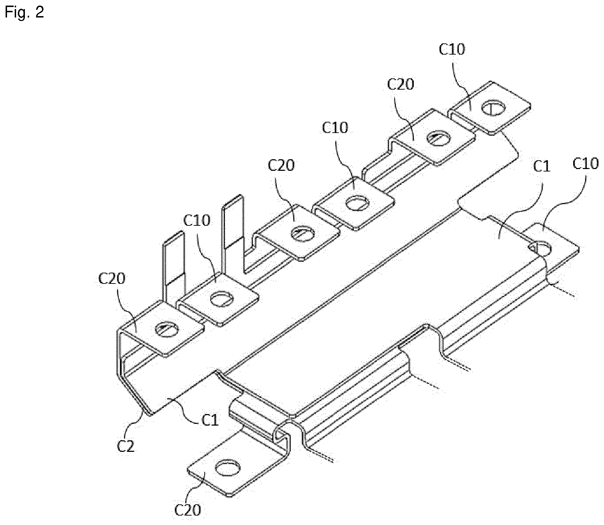

En référence aux figures 1 et 2, le bloc capacitif 12 comprend également au moins deux conducteurs C1, C2, disposés selon des plans parallèles distincts mais à proximité l'un de l'autre. Notamment, les conducteurs C1, C2 sont superposés l'un sur l'autre. Un premier conducteur C1 est relié aux bornes négatives respectives des éléments capacitifs 121, 122 du bloc capacitif 12. Un deuxième conducteur C2 est relié aux bornes positives respectives des éléments capacitifs 121, 122 du bloc capacitif 12. À cet effet, le bloc capacitif 12 peut comprendre des premières soudures S1 permettant de relier le premier conducteur C1 et les bornes négatives des éléments capacitifs 121, 122. En figure 1, le premier conducteur C1 est par exemple soudé sur une face du premier élément capacitif 121. Une portion du premier conducteur C1 passe entre les éléments capacitifs 121, 122 pour venir se connecter à une face opposée du deuxième élément capacitif 122. De même, le bloc capacitif 12 peut comprendre des secondes soudures S2 permettant de relier le deuxième conducteur C2 et les bornes positives des éléments capacitifs 121, 122. En figure 1, le deuxième conducteur C2 est par exemple soudé sur une face du deuxième élément capacitif 122. Une portion du deuxième conducteur C2 passe entre les éléments capacitifs 121, 122 pour venir se connecter à une face opposée du premier élément capacitif 121.

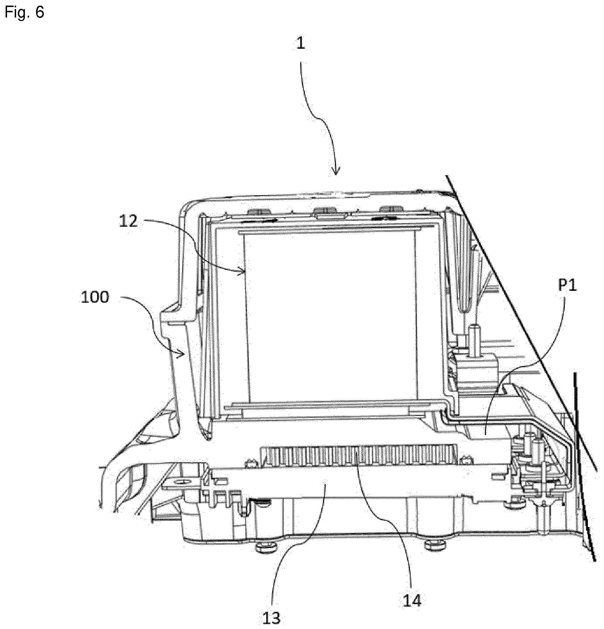

Par ailleurs, les conducteurs C1, C2 sont également situés à proximité d'une paroi P1 dudit logement de l'équipement électrique ou à proximité d'autres composants pouvant être situés dans ledit logement de l'équipement électrique. Par exemple, comme illustré en figure 6, l'équipement électrique 1, en l'espèce un onduleur, comprend notamment un bloc capacitif 12 et un module électronique de puissance 13 séparés par un circuit de refroidissement 14. Par ailleurs, le premier conducteur C1 est à proximité d'une paroi P1 du logement 100. Ladite paroi P1 est comprise notamment dans une face du circuit de refroidissement 14 destiné à refroidir des composants de l'équipement électrique 1, en particulier le bloc capacitif 12.

En référence à la figure 2, chaque conducteur C1, C2 comprend respectivement au moins une borne de connexion C10, C20 permettant de connecter les bornes négatives et positives du bloc capacitif 12 au reste du système afin notamment de distribuer l'énergie électrique au système de motorisation électrique. Par exemple, les bornes de connexion C10, C20 des conducteurs C1, C2 sont connectées à des bornes d'un module électronique de puissance 13.

Les bornes de connexion C10, C20 peuvent par exemple désigner une portion des conducteurs C1, C2. Afin de distribuer l'énergie électrique à d'autres composants, ces portions sont par exemple percées d'un ou plusieurs orifices, dans lesquels un connecteur est vissé. Ces portions peuvent être reliées au connecteur par d'autres moyens, par exemple par soudage.

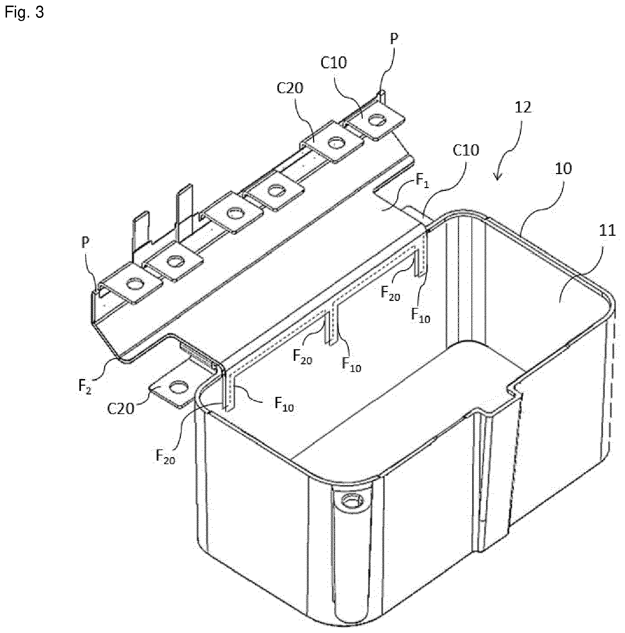

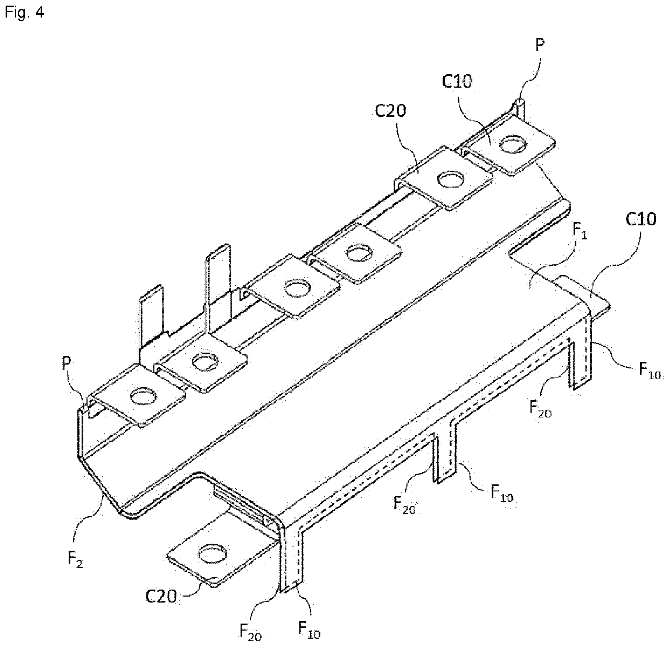

En référence aux figures 3 et 4, afin d'isoler électriquement les conducteurs C1, C2 du logement 100 et afin d'isoler électriquement les conducteurs C1, C2 l'un de l'autre et éviter ainsi tout court-circuit, le bloc capacitif 12 comprend également un film isolant. Ledit film isolant désigne un film replié sur lui-même. On désigne par « première partie F₁ » et « deuxième partie F₂ » chaque partie du film isolant située de part et d'autre de la pliure P.

Selon la forme de réalisation présentée en référence aux figures 3 et 4, la première partie F₁ est adaptée pour être placée contre le conducteur parmi les au moins deux conducteurs C1, C2, le plus proche du logement 100, de manière à isoler électriquement ce conducteur du reste du logement 100. Selon la forme de réalisation présentée, la première partie F₁ est placée contre la paroi du premier conducteur C1.

La première partie F₁ peut être maintenue et fixée contre la surface de ce premier conducteur C1 notamment en utilisant une matière adhésive telle que de la colle.

Cependant, on pourrait se passer de matière adhésive pour maintenir la première partie F₁ du film isolant contre la surface du premier conducteur C1. C'est en particulier le cas lorsque le film isolant est suffisamment rigide pour être plié avant montage sur ledit premier conducteur C1 et conserver sa forme une fois monté sur ledit premier conducteur C1. Ainsi la durée de vie d'une matière adhésive n'impacte pas la longévité du bloc capacitif 12.

L'extrémité de la première partie F₁ orientée vers la cavité 11 du boîtier 10 comprend au moins une excroissance F₁₀. Ladite excroissance F₁₀ désigne une partie en saillie de la première partie F₁. Cette excroissance F₁₀ est configurée pour s'étendre dans la cavité 11 du boîtier 10 afin d'être prise et fixée dans le matériau de remplissage de la cavité 11 du boîtier 10.

Par ailleurs, au vu de la position de la première partie F₁, la deuxième partie F₂ est adaptée pour être insérée entre lesdits conducteurs C1, C2. Autrement dit, la deuxième partie F₂ est maintenue en étant prise en sandwich entre les deux conducteurs C1, C2 du bloc capacitif 12. Ladite deuxième partie F₂ est configurée pour isoler lesdits conducteurs C1, C2 l'un de l'autre et éviter tout court-circuit entre eux.

L'extrémité de la deuxième partie F₂ orientée vers la cavité 11 du boîtier 10 comprend au moins une excroissance F₂₀. Ladite excroissance F₂₀ désigne une partie en saillie de la deuxième partie F₂. Cette excroissance F₂₀ est configurée pour s'étendre dans la cavité 11 du boîtier 10 afin d'être prise et fixée dans le matériau de remplissage de la cavité 11 du boîtier 10.

La pliure P du film isolant est configurée de manière à laisser un accès libre aux bornes de connexion C10, C20, ledit accès permettant de connecter facilement les bornes de connexion C10, C20 au reste du système afin notamment de distribuer l'énergie électrique au système de motorisation électrique. Par exemple, en référence à la figure 4, la pliure P comprend au moins un orifice permettant un accès aux bornes de connexion C10, C20.

Le film isolant est notamment constitué de matière plastique.

En particulier, ledit matériau de remplissage est fluide lors du remplissage de la cavité 11 du boîtier 10, puis devient solide après une étape de polymérisation. Notamment le matériau de remplissage est une substance polymérisable, telle qu'une résine polymérisable par exemple, notamment une résine époxy.

Ainsi, la fixation et le maintien du film isolant sont assurés d'un côté par les excroissances F₁₀, F₂₀ s'étendant dans le matériau de remplissage et d'un côté par la pliure P.

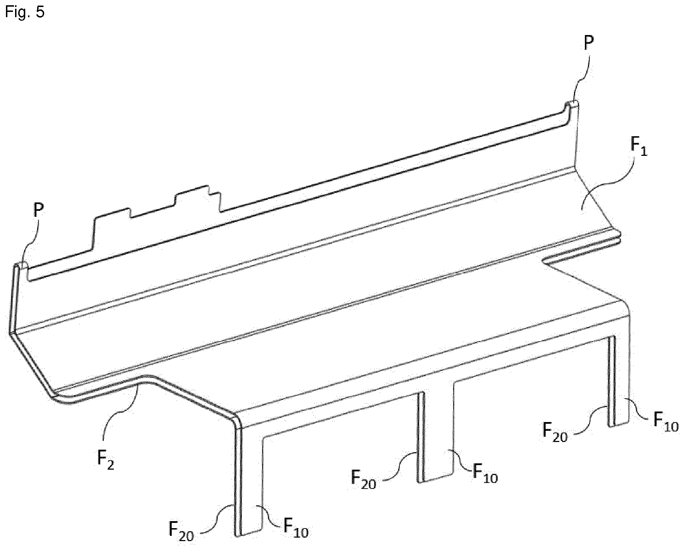

En référence à la figure 5, il est représenté le film isolant seul, comprenant la première face F₁, la deuxième F₂ et leurs excroissances F₁₀, F₂₀ respectives.

## Revendications

1. Dispositif électrique comprenant :
un boîtier (10) comprenant une cavité (11) recevant un composant électrique, et
au moins deux conducteurs (C1, C2) connectés au composant électrique de manière à l'alimenter en énergie électrique, les deux conducteurs (C1, C2) étant superposés et s'étendant parallèlement,
ledit dispositif étant **caractérisé en ce qu'**il comprend un film isolant électrique replié sur lui-même autour d'une pliure (P), et dont une première partie (F₁) située d'un côté de la pliure (P) vient contre une surface d'un premier conducteur (C1) de manière à l'isoler électriquement, et une deuxième partie (F₂) située de l'autre côté de la pliure (P) est insérée entre les deux conducteurs (C1, C2) de manière à les isoler électriquement l'un de l'autre.

2. Dispositif électrique selon la revendication précédente, dans lequel la pliure (P) du film isolant comprend au moins une ouverture adaptée pour laisser un accès libre aux conducteurs (C1, C2).

3. Dispositif électrique selon l'une des revendications précédentes, dans lequel la première partie (F₁) et la deuxième partie (F₂) du film isolant possèdent chacune au moins une excroissance (F₁₀, F₂₀) configurée pour s'insérer dans la cavité (11) du boîtier (10) et pour être prise dans un matériau de remplissage de la cavité (11) du boîtier (10).

4. Dispositif électrique selon l'une des revendications précédentes, formant un bloc capacitif (12), et dans lequel le composant électrique est une bobine capacitive.

5. Dispositif électrique selon l'une des revendications 1 à 4, dans lequel la première partie (F₁) du film isolant présente au moins un pli de manière à épouser la surface du premier conducteur (C1) et est maintenue contre ladite surface du premier conducteur (C1) uniquement par l'excroissance (F₁₀) et la pliure (P).

6. Dispositif électrique selon l'une des revendications 1 à 4, dans lequel la première partie (F₁) est maintenue sur la surface du premier conducteur (C1) par une matière adhésive.

7. Dispositif électrique selon l'une des revendications précédentes, dans lequel le film isolant est en plastique.

8. Equipement électrique (1) comprenant un logement (100) et un dispositif électrique selon l'une des revendications précédentes logé dans ledit logement (100), équipement électrique (1) dans lequel ledit film isolant électrique, et en particulier la première partie (F₁) du film isolant électrique, est configuré pour isoler électriquement le premier conducteur (C1) d'une paroi (P1) dudit logement (100) de l'équipement électrique (1) ou d'autres composants de l'équipement électrique (1) situés dans ledit logement (100) de l'équipement électrique (1), ledit film isolant électrique, et en particulier la deuxième partie (F₂) du film isolant électrique, est configuré pour isoler les conducteurs (C1, C2) les uns des autres.

9. Equipement électrique (1) selon la revendication précédente, configuré pour être embarqué dans un véhicule, et formant un onduleur configuré de manière à alimenter un moteur électrique entrainant le véhicule depuis une batterie, ou un convertisseur continu-continu configuré pour convertir une tension entre une batterie d'alimentation haute tension et une batterie d'alimentation basse tension, ou un chargeur électrique configuré pour convertir une tension entre un réseau électrique extérieur au véhicule et une batterie du véhicule.

## Patentansprüche

1. Elektrische Vorrichtung, die enthält:
ein Gehäuse (10), das einen Hohlraum (11) enthält, der ein elektrisches Bauteil aufnimmt, und
mindestens zwei Leiter (C1, C2), die mit dem elektrischen Bauteil verbunden sind, um es mit elektrischer Energie zu versorgen, wobei die zwei Leiter (C1, C2) übereinander angeordnet sind und sich parallel erstrecken,
wobei die Vorrichtung **dadurch gekennzeichnet ist, dass** sie eine elektrisch isolierende Folie enthält, die um einen Falz (P) auf sich selbst umgebogen ist, und von der ein auf einer Seite des Falzes (P) befindlicher erster Teil (F₁) gegen eine Fläche eines ersten Leiters (C1) zu liegen kommt, um ihn elektrisch zu isolieren, und ein auf der anderen Seite des Falzes (P) befindlicher zweiter Teil (F₂) zwischen die zwei Leiter (C1, C2) eingefügt ist, um sie elektrisch voneinander zu isolieren.

2. Elektrische Vorrichtung nach dem vorhergehenden Anspruch, wobei der Falz (P) der Isolierfolie mindestens eine Öffnung enthält, die geeignet ist, einen freien Zugang zu den Leitern (C1, C2) zu lassen.

3. Elektrische Vorrichtung nach einem der vorhergehenden Ansprüche, wobei der erste Teil (F₁) und der zweite Teil (F₂) der Isolierfolie je mindestens eine Ausstülpung (F₁₀, F₂₀) besitzen, die konfiguriert ist, sich in den Hohlraum (11) des Gehäuses (10) einzufügen und in einem Füllmaterial des Hohlraums (11) des Gehäuses (10) festgehalten zu werden.

4. Elektrische Vorrichtung nach einem der vorhergehenden Ansprüche, die einen kapazitiven Block (12) bildet, und wobei das elektrische Bauteil eine kapazitive Spule ist.

5. Elektrische Vorrichtung nach einem der Ansprüche 1 bis 4, wobei der erste Teil (F₁) der Isolierfolie mindestens einen Knick aufweist, um sich an die Fläche des ersten Leiters (C1) anzupassen, und nur durch die Ausstülpung (ₙ₁₀) und den Falz (P) gegen die Fläche des ersten Leiters (C1) gehalten wird.

6. Elektrische Vorrichtung nach einem der Ansprüche 1 bis 4, wobei der erste Teil (F₁) durch einen Klebstoff auf der Fläche des ersten Leiters (C1) gehalten wird.

7. Elektrische Vorrichtung nach einem der vorhergehenden Ansprüche, wobei die Isolierfolie aus Kunststoff ist.

8. Elektrisches Gerät (1), das eine Aufnahme (100) und eine in der Aufnahme (100) untergebrachte elektrische Vorrichtung nach einem der vorhergehenden Ansprüche enthält, elektrisches Gerät (1), bei dem die elektrisch isolierende Folie, und insbesondere der erste Teil (F₁) des elektrisch isolierenden Folie, konfiguriert ist, den ersten Leiter (C1) von einer Wand (P1) der Aufnahme (100) des elektrischen Geräts (1) oder anderen Bauteilen des elektrischen Geräts (1) elektrisch zu isolieren, die sich in der Aufnahme (100) des elektrischen Geräts (1) befinden, wobei die elektrisch isolierende Folie, und insbesondere der zweite Teil (F₂) der elektrisch isolierenden Folie, konfiguriert ist, die Leiter (C1, C2) voneinander zu isolieren.

9. Elektrisches Gerät (1) nach dem vorhergehenden Anspruch, das konfiguriert ist, an Bord eines Fahrzeugs eingebaut zu werden, und einen Wechselrichter, der konfiguriert ist, einen das Fahrzeug antreibenden Elektromotor von einer Batterie aus zu speisen, oder einen Gleichstrom-Gleichstrom-Wandler, der konfiguriert ist, eine Spannung zwischen einer Hochspannungs-Speisebatterie und einer Niederspannungs-Speisebatterie umzuwandeln, oder ein elektrisches Ladegerät bildet, das konfiguriert ist, eine Spannung zwischen einem Stromnetz außerhalb des Fahrzeugs und einer Batterie des Fahrzeugs umzuwandeln.

## Claims

1. Electrical device comprising:
a casing (10) comprising a cavity (11) receiving an electrical component, and
at least two conductors (C1, C2) connected to the electrical component so as to supply it with electrical energy, the two conductors (C1, C2) being superposed and extending in parallel,
said device being **characterized in that** it comprises an electrically insulating film folded on itself around a fold (P), and of which a first part (F₁) situated on one side of the fold (P) covers a surface of a first conductor (C1) so as to electrically insulate it, and a second part (F₂) situated on the other side of the fold (P) is inserted between the two conductors (C1, C2) so as to electrically insulate them from one another.

2. Electrical device according to the preceding claim, wherein the fold (P) of the insulating film comprises at least one opening suitable for allowing free access to the conductors (C1, C2).

3. Electrical device according to one of the preceding claims, wherein the first part (F₁) and the second part (F₂) of the insulating film each have at least one protuberance (F₁₀, F₂₀) configured to be inserted into the cavity (11) of the housing (10) and to be caught in a filling material of the cavity (11) of the housing (10).

4. Electrical device according to one of the preceding claims, forming a capacitive block (12), and wherein the electrical component is a capacitive coil.

5. Electrical device according to one of Claims 1 to 4, wherein the first part (F₁) of the insulating film has at least one crease so as to hug the surface of the first conductor (C1) and is held against said surface of the first conductor (C1) only by the protuberance (F₁₀) and the fold (P).

6. Electrical device according to one of Claims 1 to 4, wherein the first part (F₁) is held on the surface of the first conductor (C1) by an adhesive material.

7. Electrical device according to one of the preceding claims, wherein the insulating film is made of plastic.

8. Electrical equipment (1) comprising a housing (100) and an electrical device according to one of the preceding claims housed in said housing (100), electrical equipment (1) in which said electrical insulating film, and in particular the first part (F₁) of the electrically insulating film, is configured to electrically insulate the first conductor (C1) from a wall (P1) of said housing (100) of the electrical equipment (1) or from other components of the electrical equipment (1) situated in said housing (100) of the electrical equipment (1), said electrically insulating film, and in particular the second part (F₂) of the electrically insulating film, is configured to insulate the conductors (C1, C2) from one another.

9. Electrical equipment (1) according to the preceding claim, configured to be installed in a vehicle, and forming an inverter configured so as to power an electric motor driving the vehicle from a battery, or a DC-DC-converter configured to convert a voltage between a high-voltage power supply battery and a low-voltage power supply battery, or an electric charger configured to convert a voltage between an electrical network external to the vehicle and a battery of the vehicle.
